# FASCICULE DE BREVET EUROPEEN

(11) **EP 1 252 804 B1**
(45) Date de publication et mention de la délivrance du brevet: **03.08.2005**
(21) Numéro de dépôt: 01903980.9
(22) Date de dépôt: 26.01.2001
(51) Int. Cl.: H05K 9/00

(54) **MODULE DE RADIOCOMMUNICATION SE PRESENTANT SOUS LA FORME D'UN MACRO COMPOSANT ELECTRONIQUE, STRUCTURE D'INTERPOSITION ET PROCEDE DE REPORT SUR UNE CARTE-MERE CORRESPONDANTS**
MAKROBAUTEILGEFORMTES KOMMUNIKATIONSENDGERÄT, ZWISCHENSTÜCK, UND VORRICHTUNG ZUR VERBINDUNG MIT EINER GRUNDPLATINE
RADIOCOMMUNICATION MODULE IN THE FORM OF AN ELECTRONIC MACRO-COMPONENT, CORRESPONDING INTERFACE STRUCTURE AND TRANSFER METHOD ONTO A MOTHERBOARD

(30) Priorité: 31.01.2000 FR 0001264; 18.02.2000 FR 0002069
(43) Date de publication de la demande: 30.10.2002
(73) Titulaire: Wavecom, 93130 Issy les Moulineaux (FR)
(72) Inventeur: KORDJANI, Bachir, F-78180 Montigny le Bretonneux (FR); JOUAN, Jacky, F-92310 Sèvres (FR)
(74) Mandataire: Vidon, Patrice
(86) Numéro de dépôt international: PCT/FR2001/000260
(87) Numéro de publication internationale: WO 2001/056347

(56) Documents cités:
- EP-A- 0 957 665
- US-A- 4 948 923
- US-A- 5 838 551
- PATENT ABSTRACTS OF JAPAN vol. 018, no. 416 (E-1588), 4 août 1994 (1994-08-04) & JP 06 125191 A (NIPPON CHEMICON CORP), 6 mai 1994 (1994-05-06)

## Description

Le domaine de l'invention est celui des radiocommunications.

Plus précisément, l'invention concerne les équipements de radiocommunication (radiotéléphone, et plus généralement tout appareil ou dispositif mettant en oeuvre des radiocommunications), et plus particulièrement les modules de radiocommunication destinés à ces équipements.

On rappelle que, classiquement US-A-5 838 551 ou EP-A-0 957 665, la plupart des équipements de radiocommunication comprennent un module de radiocommunications présentant une carte, c'est-à-dire un circuit imprimé, sur laquelle sont soudés des composants, une structure de blindage et un connecteur mécanique permettant l'interconnexion du module avec d'autres éléments, tels qu'une carte-mère.

Les composants soudés sur le circuit imprimé peuvent assurer en particulier des fonctions de traitement numérique, de traitement analogique, et/ou de traitement radiofréquence. La structure de blindage permet de blinder électromagnétiquement le module de radiocommunication, et est classiquement constituée de deux ceintures, disposées respectivement sur chacune des faces du circuit intégré, et de deux capots qui peuvent être respectivement clipsés sur chacune des faces du module.

Une architecture classique pour les modules de radiocommunication de type GSM consiste en une carte électronique, réalisée sur un substrat organique, et enfermée dans une enceinte métallique assurant la fonctionnalité de blindage électromagnétique. Cette carte est interconnectée via des connecteurs de type carte à carte ou de type carte à câble. La carte peut être ensuite reportée sur une carte mère mécaniquement par visserie, ou par soudure de broches métalliques.

Dans le domaine des radiocommunications, l'une des préoccupations principales des constructeurs est de concevoir et de produire des composants et des modules de radiocommunications qui soient peu encombrants, de coût réduit, et d'une grande simplicité de montage, et notamment en ce qui concerne le report sur un circuit imprimé ou une carte mère.

Pour satisfaire à cet objectif triple, les spécialistes en radiocommunications ont envisagé plusieurs solutions.

Ainsi, Ericsson (marque déposée) a présenté un module radiofréquence, comprenant un circuit intégré réalisé sur substrat céramique, dans lequel des billes ou des colonnes de soudure étaient utilisées pour assurer simultanément le passage de signaux électriques, et le report du module sur une carte mère, selon une technologie CMS (Composants Montés en Surface).

IBM (marque déposée) a également proposé la conception d'un composant radiofréquence, pour lequel une première rangée de billes de soudure assurait le passage des signaux électriques et une seconde rangée de billes de soudure permettait le blindage du composant, ces billes permettant en outre de souder le composant sur un circuit.

D'autres constructeurs du domaine de l'électronique ont encore pensé à concevoir des modules hybrides, comprenant plusieurs composants de niveau d'assemblage « 1 », pour lesquels des billes ou des colonnes de soudure remplissaient simultanément les fonctionnalités d'interconnexion électrique et de report du module sur une carte mère.

Cependant, en dépit des nombreux efforts de recherche pour tenter de satisfaire aux trois critères de faible coût, faible taille, et facilité de montage et de report, il n'a pas encore été possible de concevoir un module de radiocommunications qui remplisse ces trois objectifs économique et techniques.

Un inconvénient des techniques de l'art antérieur est notamment que le report des modules de radiocommunication sur une carte mère ne se fait pas de manière standard, selon une technique de refusion similaire à celle utilisée pour la soudure d'un composant sur une carte.

Un autre inconvénient de ces techniques de l'art antérieur est que les modules de radiocommunication obtenus selon l'une de ces techniques sont d'une grande épaisseur.

Encore un autre inconvénient de ces techniques de l'art antérieur est que les modules de radiocommunication obtenus selon l'une de ces techniques sont coûteux.

L'invention a notamment pour objectif de pallier ces inconvénients de l'art antérieur.

Plus précisément, un objectif de l'invention est de fournir un module de radiocommunication qui soit de coût réduit.

Un autre objectif de l'invention est de mettre en oeuvre un module de radiocommunication de faible épaisseur.

Encore un autre objectif de l'invention est de fournir un module de radiocommunication qui puisse être reporté sur une carte mère selon une technique standard de refusion similaire à celle utilisée pour la fixation des composants montés en surface, de manière à pouvoir assurer un report en environnement industriel de volume.

Ces objectifs, ainsi que d'autres qui apparaîtront par la suite sont atteints selon l'invention, à l'aide d'un module pour équipement de radiocommunication, destiné à être reporté sur une carte mère et comprenant des composants montés sur un circuit imprimé et assurant au moins une des fonctions suivantes : traitement RF. traitement numérique et traitement analogique, comprenant un jeu d'éléments conducteurs, distribués sur la face inférieure du circuit imprimé, et réalisés de façon que le jeu d'éléments conducteurs constitue à la fois :
- des moyens de blindage électromagnétique de la face inférieure du circuit imprimé ;
- des moyens d'interconnexion électrique, assurant le passage de signaux électriques vers et/ou depuis la carte mère ; et
- des moyens de report du module de radiocommunication sur la carte mère :
   de façon que le module de radiocommunication forme un macro-composant électronique.

Par composant, on entend ici tout type de composants, et notamment aussi bien les composants de niveau d'assemblage "1" (composants unitaires, tels qu'une puce, une capacité, une résistance, une inductance....) que les composants de niveau d'assemblage "2" (composants plus complexes, tels que les boîtiers ou les circuits intégrés).

Ainsi, l'invention repose sur une approche tout à fait nouvelle et inventive de la conception de modules de radiocommunication, qui satisfont simultanément aux critères de faible coût, de faible encombrement, et de facilité de report sur une carte mère.

En effet, dans le domaine de l'électronique, et a fortiori des radiocommunications, l'homme du métier a toujours été réticent à utiliser un élément unique pour remplir des fonctionnalités distinctes. Il s'agit en effet d'un domaine dans lequel les interactions entre éléments et/ou composants sont très fortes, et rendent donc souvent imprévisible le fonctionnement d'un module complexe. Une telle prévision est d'autant plus difficile à réaliser que le module regroupe un grand nombre de composants, et que, de surcroît, un même élément du module peut cumuler plusieurs fonctionnalités distinctes.

La combinaison de deux fonctions, telles que l'interconnexion électrique et le blindage électromagnétique par exemple, au sein d'un même élément tel qu'une bille de soudure, et a fortiori, la mise en oeuvre d'un unique jeu d'éléments conducteurs pour réaliser simultanément l'interconnexion électrique, le blindage électromagnétique et le report du module sur une carte mère, résulte donc d'une démarche complexe.

En effet, l'homme du métier qui aurait envisagé une telle combinaison triple de fonctionnalités au sein d'un même élément aurait été naturellement enclin à rejeter cette solution pour des raisons techniques de non-faisabilité ou de non-maîtrise des effets dus à chacune des fonctionnalités. Un module de radiocommunications comporte en effet, d'une part, des composants de niveaux d'assemblage « 1 » et « 2 », et d'autre part, un circuit imprimé qui peut être multi-face. Un tel module subit donc généralement plusieurs étapes dites de refusion, et l'homme du métier considère qu'il n'est pas possible d'effectuer plus de deux refusions (sinon, certains composants préalablement soudés pourraient se détacher au cours de cette étape supplémentaire. De plus, chaque passage en refusion provoque un vieillissement prématuré et important des soudures).

Selon une caractéristique avantageuse de l'invention, le module de radiocommunication est compris dans un dispositif appartenant au groupe comprenant :
- des terminaux de radiocommunication ;
- des dispositifs, autres que les terminaux de radiocommunication, nécessitant une fonctionnalité de communication sans fil ;
- des modems.

Ainsi, le module réalisé selon l'invention trouve de nombreuses applications dans le domaine des radiocommunications, et peut notamment être utilisé dans les terminaux de radiocommunication du type des téléphones mobiles par exemple.

Avantageusement, le jeu d'éléments conducteurs comprend un premier sous-jeu d'éléments conducteurs, assurant le blindage électromagnétique du module, et un second sous-jeu d'éléments conducteurs, assurant l'interconnexion électrique, les premier et second sous-jeux d'éléments conducteurs assurant ensemble le report sur la carte mère.

Contrairement aux techniques de l'art antérieur, un même jeu d'éléments conducteurs réalise donc simultanément les trois fonctions de blindage électromagnétique, d'interconnexion électrique, et de report sur la carte mère. Une telle combinaison triple de fonctionnalités permet ainsi de réduire l'encombrement et le coût du module de radiocommunication selon l'invention.

Selon une technique avantageuse de l'invention, les éléments conducteurs appartiennent au groupe comprenant :
- des colonnes ;
- des billes ;
- des dépôts de soudure et/ou de crème à braser ;
- des inserts;
- des lyres.

Par lyres, on entend ici les pattes d'un composant ayant une forme de lyre. On peut ainsi envisager d'utiliser des billes de soudure, ou préférentiellement des colonnes de soudure, moins encombrantes. Ces billes ou colonnes de soudure ne fondent pas (par exemple, soudure haute température). En effet, les colonnes de soudure permettent d'assurer une hauteur suffisante entre la carte mère et la face inférieure du circuit imprimé, et d'éviter ainsi que les composants fixés sur la face inférieure du circuit imprimé ne viennent en contact avec la carte mère, tout en occupant une faible surface du circuit imprimé et de la carte mère.

Plus généralement, les éléments conducteurs distribués sur la face inférieure du circuit imprimé peuvent consister en tout type de contact conducteur permettant de réaliser une liaison mécanique et électrique entre le module de radiocommunication, présenté sous la forme d'un macro composant électronique, et une carte mère.

Selon un mode de réalisation avantageux de l'invention, le module de radiocommunication comprend une structure d'interposition dont une première face supporte le jeu d'éléments conducteurs, de façon à permettre un report de la structure d'interposition, par sa première face, sur la face inférieure du circuit imprimé, la structure d'interposition étant reportée par sa seconde face sur la carte mère.

Une telle structure d'interposition permet en effet de maintenir une distance minimale entre le module de radiocommunications et la carte mère, et plus précisément entre la face inférieure du circuit imprimé et la carte mère, de façon à ce que les composants fixés sur la face inférieure du circuit imprimé ne soient pas en contact avec la carte mère. Un telle distance peut être sensiblement de l'ordre de 1.5mm, voire une distance inférieure.

Par ailleurs, la structure d'interposition est choisie de manière à présenter un coefficient de dilatation thermique qui soit compatible avec le coefficient de dilatation thermique du module de radiocommunication, de façon à éviter d'éventuels problèmes de cisaillement.

Selon une caractéristique avantageuse, les éléments supportés par la première face de la structure d'interposition sont traversants et font saillie sur la seconde face de la structure d'interposition, de façon à permettre le report de la structure d'interposition, par sa seconde face, sur la carte mère.

Selon une autre caractéristique avantageuse de l'invention, chacun des éléments supportés par la première face de la structure d'interposition est relié à une première extrémité d'une ouverture traversante conductrice, une seconde extrémité de chaque ouverture traversante étant reliée à un élément d'un jeu d'éléments conducteurs complémentaires distribués sur la seconde face de la structure d'interposition, le jeu d'éléments conducteurs complémentaires permettant le report de la structure d'interposition, par sa seconde face, sur la carte mère

Selon un mode de réalisation avantageux, la structure d'interposition peut être retirée après que le module de radiocommunication a été reporté sur la carte mère.

Ainsi, on peut par exemple envisager que la structure d'interposition soit retirée après le report du module sur la carte mère, par exemple par une technique de dissolution chimique de la structure.

Avantageusement, le circuit imprimé est réalisé avec un substrat organique. Les substrats organiques sont en effet généralement moins coûteux que d'autres types de substrats, notamment que des substrats en céramique.

Selon une caractéristique avantageuse, le circuit imprimé appartient au groupe comprenant :
- des circuits imprimés mono-faces et mono-couches;
- des circuits imprimés multi-faces et mono-couches :
- des circuits imprimés mono-faces et multi-couches;
- des circuits imprimés multi-faces et multi-couches.

Le module de radiocommunication peut en effet atteindre un niveau de complexité élevé, et comporter un grand nombre de composants, tant sur la face inférieure que supérieure du circuit imprimé, les liaisons électriques entre les différents composants pouvant être superposées, dans le circuit imprimé, sur plusieurs couches. Alternativement, le module de radiocommunication peut être de complexité réduite et être constitué d'un circuit imprimé mono-face et mono-couche. Ainsi, l'invention est adaptée à tous les types de modules multi-composants.

L'invention concerne également la structure d'interposition, permettant le report d'un module de radiocommunication sur une carte mère, une première face de la structure d'interposition supportant un jeu d'éléments conducteurs permettant un report de la structure d'interposition, par sa première face, sur la face inférieure d'un circuit imprimé compris dans le module de radiocommunication, la structure d'interposition étant reportée par sa seconde face sur la carte mère.

L'invention concerne encore un procédé de report sur une carte mère d'un module de radiocommunication, les composants du module étant soudés sur un circuit imprimé au cours d'au moins une première étape de refusion, le procédé comprenant au moins une étape supplémentaire de refusion, permettant le report du module de radiocommunication sur la carte mère.

Selon un autre mode de réalisation avantageux, le module de radiocommunication comprenant une structure d'interposition dont une première face supporte un jeu d'éléments conducteurs, ladite au moins une première étape de refusion du procédé permet également le report de la structure d'interposition, par sa première face, sur la face inférieure du circuit imprimé, et l'étape supplémentaire de refusion permet le report de la structure d'interposition, par sa seconde face, sur la carte mère.

D'autres caractéristiques et avantages de l'invention apparaîtront plus clairement à la lecture de la description suivante d'un mode de réalisation préférentiel, donné à titre de simple exemple illustratif et non limitatif, et des dessins annexés, parmi lesquels :
- la figure 1 présente un module de radiocommunication selon l'invention en vue de dessous ;
- la figure 2 illustre un détail de la zone 14 de la figure 1 ;
- la figure 3 présente le module de la figure 1 après report sur une carte mère.

Le principe général de l'invention repose sur l'utilisation d'un ensemble d'éléments conducteurs pour réaliser les trois fonctionnalités de blindage électromagnétique, d'interconnexion électrique, et de report sur une carte mère.

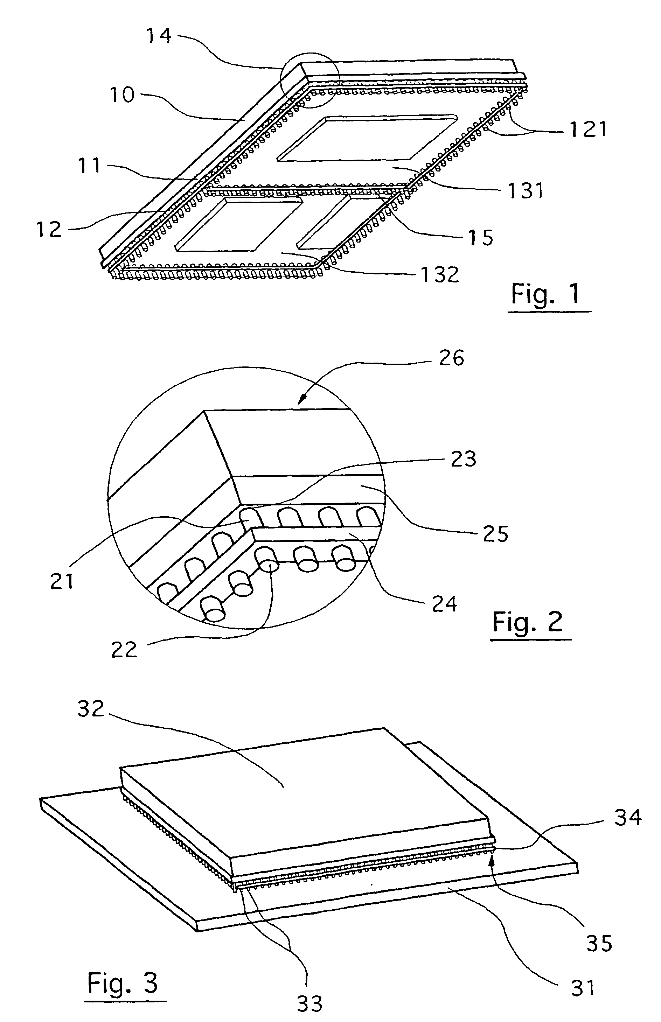

On présente, en relation avec la figure 1, un mode de réalisation d'un module de radiocommunication selon l'invention.

Le module de radiocommunication 10 comprend un circuit imprimé 11, auquel a été fixée une structure d'interposition 12. Le circuit imprimé 11 présente deux zones 131 et 132, correspondant par exemple respectivement à une zone de traitement radiofréquence et à une zone de traitement numérique et/ou en bande de base. Ces deux zones traitant des types de signaux très différents, elles sont avantageusement isolées par une rangée 15 de colonnes métalliques. La structure d'interposition 12 présente un ensemble d'éléments conducteurs 121 permettant notamment le report de la structure 12 sur la face inférieure du circuit imprimé 11. Une zone14 est illustrée en détails à l'échelle 15 par la figure 2.

Sur l'exemple décrit, les éléments conducteurs sont des colonnes. Une colonne métallique 21 traverse de part en part un corps interposeur 24, qui peut par exemple être réalisé en matériau plastique d'une épaisseur sensiblement égale à 0,5mm. La colonne métallique 21 peut être fixée sur la face inférieure du circuit imprimé 25 par une soudure haute température 23. Le module 26 peut être rapporté sur une carte mère par une soudure standard 22 de la colonne 21. Une colonne 21 peut être de longueur sensiblement égale à 1,5mm et de diamètre sensiblement égal à 0.4 mm. L'espacement entre deux colonnes 21 successives peut être égal à 1,27mm.

Les colonnes peuvent être remplacées par divers éléments tels que des billes de soudure, des inserts, des lyres, des dépôts de crème à braser ...

Selon un autre mode de réalisation de l'invention, la structure d'interposition peut être rapportée au circuit imprimé d'une part, et à une carte mère d'autre part, à l'aide de deux éléments conducteurs, par exemple des plots de crème à braser, déposés sur chacune des faces du corps interposeur 24, ces deux éléments étant reliés par un trou métallisé, par exemple en cuivre. Les deux plots de crème à braser ont alors une épaisseur telle que la distance entre la face inférieure du circuit imprimé et la carte mère soit sensiblement égale à 1,5mm.

La structure d'interposition peut être définitive ou temporaire. Dans ce dernier cas, elle peut être retirée par dissolution chimique après report de la carte mère. Il est également possible qu'il n'y ait pas de structure d'interposition.

La figure 3 présente le module de radiocommunication de la figure 1 après report sur une carte mère 31. Une structure d'interposition 34 est fixée au module de radiocommunication 32 d'une part, et à la carte mère 31 d'autre part. Les soudures 33 entre la carte mère 31 et les colonnes métalliques 35 de la structure d'interposition 34 peuvent être de type CMS (Composants Montés en Surface).

## Revendications

1. Module pour équipement de radiocommunication (10 ; 26 ; 32), destiné à être reporté sur une carte mère (31) et comprenant des composants montés sur un circuit imprimé (11 ; 25) et assurant au moins une des fonctions suivantes : traitement RF, traitement numérique et traitement analogique,
**caractérisé en ce que** ledit module comprend un jeu d'éléments conducteurs (121), distribués sur la face inférieure dudit circuit imprimé, et réalisés de façon que ledit jeu d'éléments conducteurs constitue des moyens de blindage électromagnétique de la face inférieure dudit circuit imprimé, et/ou des moyens d'interconnexion électrique, assurant le passage de signaux électriques vers et/ou depuis ladite carte mère, et/ou des moyens de report dudit module de radiocommunication sur ladite carte mère, de façon que ledit module de radiocommunication forme un macro-composant électronique,
**en ce que** ledit module comprend une structure d'interposition (12 ; 24 ; 34) dont :
- une première face supporte ledit jeu d'éléments conducteurs, de façon à permettre un report de la structure d'interposition, par sa première face, sur la face inférieure du circuit imprimé,
- une seconde face, destinée à être reportée sur la carte mère, de façon à permettre le report du module de radiocommunication sur la carte mère.

2. Module de radiocommunication selon la revendication 1, **caractérisé en ce que** le jeu d'éléments conducteurs (121), distribués sur la face inférieure dudit circuit imprimé, est réalisés de façon que ledit jeu d'éléments conducteurs constitue à la fois :
- des moyens de blindage électromagnétique de la face inférieure dudit circuit imprimé ;
- des moyens d'interconnexion électrique, assurant le passage de signaux électriques vers et/ou depuis ladite carte mère ; et
- des moyens de report dudit module de radiocommunication sur ladite carte mère.

3. Module de radiocommunication selon l'une quelconque des revendications 1 et 2, **caractérisé en ce qu'**il est compris dans un dispositif appartenant au groupe comprenant :
- des terminaux de radiocommunication ;
- des dispositifs, autres que les terminaux de radiocommunication, nécessitant une fonctionnalité de communication sans fil ;
- des modems.

4. Module de radiocommunication selon l'une quelconque des revendications 2 et 3, **caractérisé en ce que** ledit jeu d'éléments conducteurs comprend un premier sous-jeu d'éléments conducteurs, assurant ledit blindage électromagnétique, et un second sous-jeu d'éléments conducteurs, assurant ladite interconnexion électrique,
et **en ce que** lesdits premier et second sous-jeux d'éléments conducteurs assurent ensemble ledit report sur la carte mère.

5. Module de radiocommunication selon l'une quelconque des revendications 1 à 4, **caractérisé en ce que** lesdits éléments conducteurs appartiennent au groupe comprenant :
- des colonnes (21 ; 35) ;
- des billes ;
- des dépôts de soudure et/ou de crème à braser ;
- des inserts;
- des lyres.

6. Module de radiocommunication selon l'une quelconque des revendications 1 à 5, **caractérisé en ce que** lesdits éléments supportés par la première face de la structure d'interposition sont traversants et font saillie sur la seconde face de la structure d'interposition, de façon à permettre ledit report de la structure d'interposition, par sa seconde face, sur la carte mère.

7. Module de radiocommunication selon l'une quelconque des revendication 1 à 5, **caractérisé en ce que** chacun desdits éléments supportés par la première face de la structure d'interposition est relié à une première extrémité d'une ouverture traversante conductrice, une seconde extrémité de chaque ouverture traversante étant reliée à un élément d'un jeu d'éléments conducteurs complémentaires distribués sur la seconde face de la structure d'interposition, ledit jeu d'éléments conducteurs complémentaires permettant ledit report de la structure d'interposition, par sa seconde face, sur la carte mère.

8. Module de radiocommunication selon l'une quelconque des revendications 1 à 7, **caractérisé en ce que** ladite structure d'interposition peut être retirée après que ledit module de radiocommunication a été reporté sur la carte mère.

9. Module de radiocommunication selon l'une quelconque des revendications 1 à 8, **caractérisé en ce que** ledit circuit imprimé est réalisé avec un substrat organique.

10. Module de radiocommunication selon l'une quelconque des revendications 1 à 9, **caractérisé en ce que** ledit circuit imprimé appartient au groupe comprenant :
- des circuits imprimés mono-faces et mono-couches;
- des circuits imprimés multi-faces et mono-couches ;
- des circuits imprimés mono-faces et multi-couches;
- des circuits imprimés multi-faces et multi-couches.

11. Structure d'interposition, permettant le report d'un module de radiocommunication sur une carte mère, **caractérisée en ce qu'**une première face de la structure d'interposition supporte un jeu d'éléments conducteurs permettant un report de la structure d'interposition, par sa première face, sur la face inférieure d'un circuit imprimé compris dans le module de radiocommunication,
et **en ce qu'**une seconde face de la structure d'interposition permet un report de la structure d'interposition sur la carte mère, de façon à permettre le report du module de radiocommunication sur la carte mère.

12. Procédé de report sur une carte mère d'un module de radiocommunication selon l'une quelconque des revendications 1 à 10, **caractérisé en ce qu'**il comprend les étapes suivantes :
- une première étape de refusion, permettant le report de la structure d'interposition, par sa première face, sur la face inférieure du circuit imprimé ;
- une étape supplémentaire de refusion, permettant le report dudit module de radiocommunication sur ladite carte mère, par report de ladite structure d'interposition, par sa seconde face, sur la carte mère.

13. Procédé selon la revendication 12, **caractérisé en ce que** la première étape de refusion permet également le report d'au moins un composant sur la face inférieure du circuit imprimé.

14. Procédé de fabrication d'un module pour équipement de radiocommunication (10 ; 26 ; 32), destiné à être reporté sur une carte mère (31) et comprenant des composants montés sur un circuit imprimé (11 ; 25) et assurant au moins une des fonctions suivantes : traitement RF, traitement numérique et traitement analogique, ledit module comprenant un jeu d'éléments conducteurs (121), distribués sur la face inférieure dudit circuit imprimé, et réalisés de façon que ledit jeu d'éléments conducteurs constitue des moyens de blindage électromagnétique de la face inférieure dudit circuit imprimé, et/ou des moyens d'interconnexion électrique, assurant le passage de signaux électriques vers et/ou depuis ladite carte mère, et/ou des moyens de report dudit module de radiocommunication sur ladite carte mère, de façon que ledit module de radiocommunication forme un macro-composant électronique,
**caractérisé en ce que** le procédé comprend une étape de report d'une structure d'interposition, par une première face supportant le jeu d'éléments conducteurs, sur la face inférieure du circuit imprimé,
et **en ce que** la structure d'interposition possède une seconde face, destinée à être reportée sur la carte mère, de façon à permettre le report du module de radiocommunication sur la carte mère.

15. Procédé selon la revendication 14, **caractérisé en ce que** l'étape de report de la structure d'interposition sur la face inférieure du circuit imprimé est effectuée par refusion,
et **en ce que** ladite refusion permet également le report d'au moins un composant sur la face inférieure du circuit imprimé.

## Patentansprüche

1. Modul für Funkkommunikationsgeräte (10; 26; 32), das auf eine Mutterkarte (31) übertragen werden soll und Komponenten umfasst, die auf einer gedruckten Schaltung (11, 25) angebracht sind und mindestens eine der folgenden Funktionen ausführen: RF-Verarbeitung, digitale Verarbeitung und analoge Verarbeitung,
**dadurch gekennzeichnet, dass** dieses Modul einen Satz von leitenden Elementen (121) umfasst, die über die untere Fläche der gedruckten Schaltung verteilt sind und so ausgeführt sind, dass der Satz von leitenden Elementen Mittel zur elektromagnetischen Abschirmung der unteren Fläche der gedruckten Schaltung und/oder elektrische Verbindungsmittel bilden, die den Durchgang von elektrischen Signalen zu und/oder von der Mutterkarte und/oder Mittel zum Übertragen des Radiokommunikationsmoduls auf diese Mutterkarte sicherstellen, so dass dieses Funkkommunikationsmodul eine elektronische Makrokomponente bildet,
dadurch, dass das Modul eine folgendes umfassende Zwischenschaltungsstruktur (12; 24; 34) aufweist:
- eine erste Fläche, die den Satz von leitenden Elementen so trägt, dass eine Übertragung der Zwischenschaltungsstruktur über die erste Fläche auf die untere Fläche der gedruckten Schaltung ermöglicht wird,
- eine zweite Fläche, die auf die Mutterkarte übertragen werden soll, so dass die Übertragung des Funkkommunikationsmoduls auf die Mutterkarte ermöglicht wird.

2. Funkkommunikationsmodul nach Anspruch 1,
**dadurch gekennzeichnet, dass** der Satz von über die untere Fläche der gedruckten Schaltung verteilten leitenden Elementen (121) so ausgeführt ist, dass der Satz leitender Elemente gleichzeitig folgendes bildet:
- Mittel zur elektromagnetischen Abschirmung der unteren Fläche der gedruckten Schaltung;
- Mittel zur elektrischen Verbindung, die den Übergang von elektrischen Signalen zu und/oder von der Mutterkarte sicherstellen und,
- Mittel zum Übertragen des Funkkommunikationsmoduls auf die Mutterkarte.

3. Funkkommunikationsmodul nach einem der Ansprüche 1 oder 2,
**dadurch gekennzeichnet, dass** es Teil einer Vorrichtung ist, die der folgendes umfassenden Gruppe angehört:
- Funkkommunikationsterminals;
- Vorrichtungen, die selbst keine Funkkommunikationsterminals sind und eine Funktion für drahtlose Kommunikation benötigen;
- Modems.

4. Funkkommunikationsmodul nach einem der Ansprüche 2 oder 3,
**dadurch gekennzeichnet, dass** der Satz von leitenden Elementen einen ersten, die elektromagnetische Abschirmung sicherstellenden Untersatz von leitenden Elementen und einen zweiten, die elektrische Verbindung sicherstellenden Untersatz von leitenden Elementen umfasst und
dass der erste und der zweite Untersatz von leitenden Elementen zusammen die Übertragung auf die Mutterkarte sicherstellen.

5. Funkkommunikationsmodul nach einem der Ansprüche 1 bis 4,
**dadurch gekennzeichnet, dass** die leitenden Elemente der folgendes umfassenden Gruppe angehören:
- Säulen (21; 35)
- kleine Kugeln;
- Schweiß- und/oder Lötmittellager;
- Einsätze;
- Ausgleichsschleifen.

6. Funkkommunikationsmodul nach einem der Ansprüche 1 bis 5,
**dadurch gekennzeichnet, dass** die von der ersten Fläche der Zwischenschaltungsstruktur getragenen Elemente durchdringend sind und auf der zweiten Fläche der Zwischenschaltungsstruktur hervorstehen, um das Übertragen der Zwischenschaltungsstruktur über die zweite Fläche auf die Mutterkarte zu ermöglichen.

7. Funkkommunikationsmodul nach einem der Ansprüche 1 bis 5,
**dadurch gekennzeichnet, dass** jedes der von der ersten Fläche der Zwischenschaltungsstruktur getragenen Elemente mit einem ersten Ende einer leitenden, durchdringenden Öffnung verbunden ist, wobei ein zweites Ende einer durchdringenden Öffnung mit einem Element eines Satzes zusätzlicher, auf der zweiten Fläche der Zwischenschaltungsstruktur verteilten leitender Elemente verbunden ist, wobei dieser Satz von zusätzlichen leitenden Elementen die Übertragung der Zwischenschaltungsstruktur über ihre zweite Fläche auf die Mutterkarte ermöglicht.

8. Funkkommunikationsmodul nach einem der Ansprüche 1 bis 7,
**dadurch gekennzeichnet, dass** die Zwischenschaltungsstruktur nach dem Übertragen des Funkkommunikationsmoduls auf die Mutterkarte entfernt werden kann.

9. Funkkommunikationsmodul nach einem der Ansprüche 1 bis 8,
**dadurch gekennzeichnet, dass** die gedruckte Schaltung mit Hilfe eines organischen Substrats hergestellt ist.

10. Funkkommunikationsmodul nach einem der Ansprüche 1 bis 9,
**dadurch gekennzeichnet, dass** die gedruckte Schaltung zu der folgendes umfassenden Gruppe gehört:
- einflächige und einschichtige gedruckte Schaltungen;
- mehrflächige und einschichtige gedruckte Schaltungen;
- einflächige und mehrschichtige gedruckte Schaltungen;
- mehrflächige und mehrschichtige gedruckte Schaltungen.

11. Zwischenschaltungsstruktur, welche die Übertragung eines Funkkommunikationsmoduls auf eine Mutterkarte ermöglicht,
**dadurch gekennzeichnet, dass** eine erste Fläche der Zwischenschaltungsstruktur einen Satz von leitenden Elementen trägt, die das Übertragen der Zwischenschaltungsstruktur über ihre erste Fläche auf die untere Fläche einer im Funkkommunikationsmodul enthaltenen gedruckten Schaltung ermöglichen, und
dass eine zweite Fläche der Zwischenschaltungsstruktur eine Übertragung des Funkkommunikationsmoduls auf die Mutterkarte ermöglicht.

12. Verfahren zum Übertragen eines Funkkommunikationsmoduls auf eine Mutterkarte nach einem der Ansprüche 1 bis 10,
**dadurch gekennzeichnet, dass** es die folgenden Schritte umfasst:
- einen ersten Schritt zum Wiederaufschmelzen von Zinn auf gedruckte Schaltungen, die das Übertragen der Zwischenschaltungsstruktur über ihre erste Fläche auf die untere Fläche der gedruckten Schaltung ermöglicht;
- einen zusätzlichen Schritt zum Wiederaufschmelzen von Zinn auf gedruckte Schaltungen, die das Übertragen des Funkkommunikationsmoduls auf die Mutterkarte durch Übertragen der Zwischenschaltungsstruktur über ihre zweite Fläche auf die Mutterkarte ermöglicht.

13. Verfahren nach Anspruch 12,
**dadurch gekennzeichnet, dass** der erste Schritt zum Wiederaufschmelzen von Zinn auf gedruckte Schaltungen ebenfalls das Übertragen von mindestens einer Komponente auf die untere Fläche der gedruckten Schaltung ermöglicht.

14. Herstellungsverfahren eines Moduls für Funkkommunikationsgeräte (10; 26; 32), das auf eine Mutterkarte (31) übertragen werden soll, auf einer gedruckten Schaltung (11; 25) aufgebrachte Komponenten umfasst und mindestens eine der folgenden Funktionen ausführen soll: RF-Verarbeitung, digitale Verarbeitung und analoge Verarbeitung, wobei dieses Modul einen Satz von leitenden Elementen (121) umfasst, die über die untere Fläche der gedruckten Schaltung verteilt sind und so ausgeführt sind, dass der Satz von leitenden Elementen Mittel zur elektromagnetischen Abschirmung der unteren Fläche der gedruckten Schaltung und/oder elektrische Verbindungsmittel bilden, die den Durchgang von elektrischen Signalen zu und/oder von der Mutterkarte und/oder Mittel zum Übertragen des Funkkommunikationsmoduls auf diese Mutterkarte sicherstellen, so dass dieses Funkkommunikationsmodul eine elektronische Makrokomponente bildet,
**dadurch gekennzeichnet, dass** das Verfahren einen Schritt zum Übertragen einer Zwischenschaltungsstruktur über eine erste, einen Satz leitender Elemente tragenden Fläche auf die untere Fläche der gedruckten Schaltung aufweist und
dass die Zwischenschaltungsstruktur eine zweite Fläche aufweist, die auf die Mutterkarte übertragen werden soll, um das Übertragen des Funkkommunikationsmoduls auf die Mutterkarte zu ermöglichen.

15. Verfahren nach Anspruch 14,
**dadurch gekennzeichnet, dass** der Schritt zum Übertragen der Zwischenschaltungsstruktur auf die untere Fläche der gedruckten Schaltung durch Wiederschmelzen des Zinns erfolgt und
dass dieses Wiederschmelzen des Zinns ebenfalls die Übertragung von mindestens einer Komponente auf die untere Fläche der gedruckten Schaltung ermöglicht.

## Claims

1. Module for radio communication equipment (10; 26; 32) intended to be mounted on a motherboard (31) and comprising components mounted on a printed circuit (11; 25) and providing at least one of the following functions: RF processing, digital processing and analogue processing, **characterized in that** the said module comprises a set of conducting elements (121), distributed over the lower face of the said printed circuit, and made in such a way that the said set of conducting elements forms means for the electromagnetic shielding of the lower face of the said printed circuit, and/or electrical interconnection means for the passage of electrical signals towards and/or from the said motherboard, and/or means for mounting the said radio communication module on the said motherboard, in such a way that the said radio communication module forms an electronic macro-component,
and **in that** the said module comprises an interposition structure (12; 24; 34) including:
- a first face which supports the said set of conducting elements, in such a way as to enable the interposition structure to be mounted by means of its first face on the lower face of the printed circuit;
- a second face, intended to be mounted on the motherboard, in such a way as to enable the radio communication module to be mounted on the motherboard.

2. Radio communication module according to Claim 1, **characterized in that** the set of conducting elements (121) distributed over the lower face of the said printed circuit is made in such a way that the said set of conducting elements simultaneously forms:
- means for the electromagnetic shielding of the lower face of the said printed circuit;
- electrical interconnection means for the passage of electrical signals towards and/or from the said motherboard;
- means for mounting the said radio communication module on the said motherboard.

3. Radio communication module according to either of Claims 1 and 2, **characterized in that** it is included in a device belonging to the group comprising:
- radio communication terminals;
- devices, other than radio communication terminals, requiring wireless communication functionality;
- modems.

4. Radio communication module according to either of Claims 2 and 3, **characterized in that** the said set of conducting elements comprises a first subset of conducting elements, providing the said electromagnetic shielding, and a second subset of conducting elements, providing the said electrical interconnection,
and **in that** the said first and second subsets of conducting elements jointly permit the said mounting on the motherboard.

5. Radio communication module according to any one of Claims 1 to 4, **characterized in that** the said conducting elements belong to the group comprising:
- columns (21; 35);
- balls;
- deposits of solder and/or solder paste;
- inserts;
- contact pins.

6. Radio communication module according to any one of Claims 1 to 5, **characterized in that** the said elements supported by the first face of the interposition structure pass through the structure and project on the second face of the interposition structure so as to permit the said mounting of the interposition structure on the motherboard by means of its second face.

7. Radio communication module according to any one of Claims 1 to 5, **characterized in that** each of the said elements supported by the first face of the interposition structure is connected to a first end of a conducting through hole, a second end of each through hole being connected to an element of a set of complementary conducting elements distributed over the second face of the interposition structure, the said set of complementary conducting elements permitting the said mounting of the interposition structure on the motherboard by means of its second face.

8. Radio communication module according to any one of Claims 1 to 7, **characterized in that** the said interposition structure can be removed after the said radio communication module has been mounted on the motherboard.

9. Radio communication module according to any one of Claims 1 to 8, **characterized in that** the said printed circuit is made with an organic substrate.

10. Radio communication module according to any one of Claims 1 to 9, **characterized in that** the said printed circuit belongs to the group comprising:
- single-face single-layer printed circuits;
- multiple-face single-layer printed circuits;
- single-face multiple-layer printed circuits;
- multiple-face multiple-layer printed circuits.

11. Interposition structure for mounting a radio communication module on a motherboard, **characterized in that** a first face of the interposition structure supports a set of conducting elements for mounting the interposition structure, by means of its first face, on the lower face of a printed circuit included in the radio communication module,
and **in that** a second face of the interposition structure enables the interposition structure to be mounted on the motherboard, so as to enable the radio communication module to be mounted on the motherboard.

12. Method for mounting a radio communication module on a motherboard according to any one of Claims 1 to 10, **characterized in that** it comprises the following steps:
- a first remelting step, enabling the interposition structure to be mounted, by means of its first face, on the lower face of the printed circuit;
- a supplementary remelting step, enabling the said radio communication module to be mounted on the said motherboard, by the mounting of the said interposition structure on the motherboard by means of its second face.

13. Method according to Claim 12, **characterized in that** the first remelting step also enables at least one component to be mounted on the lower face of the printed circuit.

14. Method for manufacturing a module for radio communication equipment (10; 26; 32), intended to be mounted on a motherboard (31) and comprising components mounted on a printed circuit (11; 25) and providing at least one of the following functions: RF processing, digital processing and analogue processing, the said module comprising a set of conducting elements (121), distributed over the lower face of the said printed circuit, and made in such a way that the said set of conducting elements forms means for the electromagnetic shielding of the lower face of the said printed circuit, and/or electrical interconnection means for the passage of electrical signals towards and/or from the said motherboard, and/or means for mounting the said radio communication module on the said motherboard, in such a way that the said radio communication module forms an electronic macro-component,
**characterized in that** the method comprises a step of mounting an interposition structure, by means of a first face supporting the set of conducting elements, on the lower face of the printed circuit,
and **in that** the interposition structure has a second face, intended to be mounted on the motherboard, in such a way as to enable the radio communication module to be mounted on the motherboard.

15. Method according to Claim 14, **characterized in that** the step of mounting the interposition structure on the lower face of the printed circuit is carried out by remelting,
and **in that** the said remelting also enables at least one component to be mounted on the lower face of the printed circuit.
